# EUROPEAN PATENT SPECIFICATION

(11) **EP 0 333 591 B1**
(45) Date of publication and mention of the grant of the patent: **29.10.1997**
(21) Application number: 89400743.4
(22) Date of filing: 16.03.1989
(51) Int. Cl.: G03F 7/075, G03F 7/36

(54) **Process for formation of resist patterns**
Verfahren zur Herstellung eines Resistbildes
Procédé pour l'obtention d'un modèle de réserve

(30) Priority: 16.03.1988 JP 60218/88; 20.01.1989 JP 12445/89
(43) Date of publication of application: 20.09.1989
(73) Proprietor: FUJITSU LIMITED, Kawasaki-shi, Kanagawa 211 (JP)
(72) Inventor: Abe, Naomichi, Setagaya-ku Tokyo 158 (JP); Motoyama, Takushi, Kawasaki-shi Kanagawa 211 (JP)
(74) Representative: Joly, Jean-Jacques

(56) References cited:
- EP-A- 0 164 598
- PATENT ABSTRACTS OF JAPAN vol. 12, no. 139 (C-491)(2986) 27 April 1988, & JP-A-62 256804 (NEC CORP.) 09 November 1987,
- PATENT ABSTRACTS OF JAPAN vol. 12, no. 220 (P-720)(3067) 23 June 1988, & JP-A-63 015240 (FUJITSU LTD) 22 January 1988,
- PATENT ABSTRACTS OF JAPAN vol. 10, no. 50 (E-384)(2107) 27 February 1986, & JP-A-60 206135 (TOSHIBA K.K.) 17 October 1985,

## Description

### BACKGROUND OF THE INVENTION

### 1. Field of the Invention

The present invention relates to a process for the formation of resist patterns, particularly negative resist patterns. The pattern formation process of the present invention can be effectively used in both a single layer resist process and a two layer resist process currently used to obtain resist patterns having a high resolution and aspect ratio on a substrate having topographic features. The resulting resist patterns can be advantageously used in the production of semiconductor devices such as large-scale integrated (LSI) circuits, very-large-scale integrated (VLSI) circuits, and bubble memory devices, and the like.

### 2. Description of the Related Art

As is well-known, a thin layer formation technology and lithography are widely utilized in the production of LSI, VLSI, and the like, for example. An important process in this technology is a resist process used in the field of fine fabrication. Generally, the resist process is classified into a single layer resist process and a multilayer resist process, such as a two layer or three layer resist process. In these resist processes, a plurality of negative-working or positive-working resist materials are used depending upon the desired results and other factors.

For example, the single layer resist process using a negative-working resist material is conducted as follows: A solution of the selected resist material is coated on a substrate and then dried to form a resist layer. The resist layer is patterned by exposure to light or radiation to which the resist material is sensitive, for example, ultraviolet radiation. As a result of this exposure, the resist material in an exposed area of the resist layer is insolubilized in a developing solution such as organic solvents. The mechanism of insolubilization is based on, for example, cross-linking of the resist material. The exposed resist layer is developed with the developing solution to remove the unexposed resist material from the resist layer, and a negative resist pattern is thus formed on the substrate. This process has a drawback, however, in that a high quality resist pattern cannot be obtained, since the substrate is swollen as a result of contact thereof with the solvent used as the developer in the wet development step.

To remove the above drawback due to wet development, the inventor created an improved resist process as disclosed in Japanese Unexamined Patent Publication (Kokai) No. 63-15240, in which the resist process or patterning process comprises coating a resist material having a polymer having a double bond or triple bond in a backbone chain thereof, as a main component, on a substrate to form a layer of the resist material, exposing a selected area of the layer to ultraviolet radiation, X-rays or electron beams, and developing the exposed layer with the down flow etching method using an oxygen-containing gas. The polymer includes, for example, 1,4-polybutadiene, 1,4-polybutadiyne or derivatives thereof, and contains one or more benzene rings and chlorine atoms in a polymeric structure thereof. Further, the oxygen-containing gas used in the development step is, for example, a mixture of oxygen and carbon tetrafluoride. According to the process of Japanese Kokai 63-15240, since specific polymers containing unsaturated bonds as well as benzene rings and chlorine atoms are used as the resist material and the exposed resist material is developed with a dry process, high quality negative resist patterns can be obtained.

The substrate used in the production of the semiconductor devices and the like, as is well-known in the art, may comprise any material such as a semiconductor, for example, silicon (Si). The substrate may have any layer such as an insulating layer, for example, SiO₂ layer or a polysilicon layer on a surface thereof, and further, may contain topographic features, i.e., concaves and convexes, on a surface thereof. The topographic features are produced, for example, when an electrically insulating layer is coated over the surface of the circuit pattern-bearing substrate, and the topographic features have a height of about 1 to 2 µm.

When the substrate to be processed has topographic features, it is difficult to use the above-described single layer resist process to obtain resist patterns of a submicron order on the substrate, because the topographic features adversely affect the resulting resist patterns. Namely, due to a disordered reflection of exposure light or radiation such as electron beams at the concaves and convexes in the resist patterns, the formation of fine resist patterns at a high accuracy is impossible.

In place of the single layer resist process, a multilayer resist process, especially a two layer resist process has been used to obtain fine resist patterns of a submicron order on the topographic features-bearing substrate. The two layer resist process generally comprises coating an organic resist material such as phenol-novolac resin or cresol-novolac resin on the substrate to level the topographic features thereof. The resulting resist layer (hereinafter "lower resist layer") is relatively thick and has a thickness of about 2 to 3 µm, for example. After formation of the lower resist layer, a polymeric resist material having a high resistance to dry etching, such as chloromethylated polydiphenyl siloxane of the structure formula: 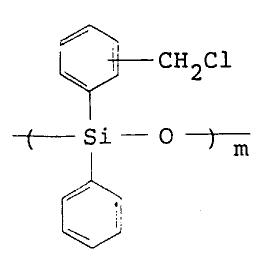 wherein m represents a polymerization degree ("SNR" commercially available from Tosoh Corporation) or a copolymer of trimethylsilylstyrene and chloromethyl styrene of the structural formula: 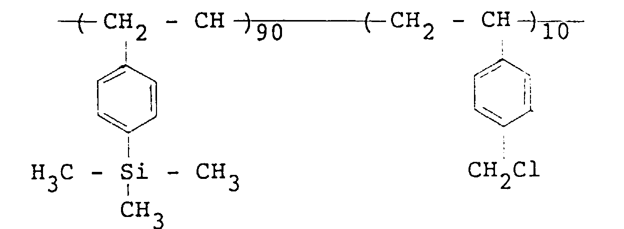 is coated on the lower resist layer. The resulting layer (hereinafter "upper resist layer") is remarkably thinner than the lower resist layer and generally has a thickness of about 0.2 to 0.5 µm. The reason why the silicon-containing polymers are suitable as the upper resist material is that these polymers also can form an SiOₓ layer having a high resistance to dry etching during the subsequent O₂-RIE (reactive ion etching) generally used to transfer a pattern of the upper resist layer to the lower resist layer.

After a two layer resist structure is produced, a pattern formation is conducted as follows: The upper resist layer is patterned by exposure to light or radiation, for example, by applying a projection exposure or contact exposure, through a mask, to the resist layer. When the resist layer is negative-working, an exposed area of the layer is insolubilized in a developing solution. The exposed upper resist layer is then developed with the developing solution to remove an unexposed area thereof, and a pattern of the upper resist layer is thus formed. Using this pattern as a mask, the underlying lower resist layer is dry etched with, for example, O₂-RIE, to transfer the pattern of the upper resist layer to the lower resist layer, and a desired negative resist pattern is finally obtained.

The above process can overcome the problems of the topographic features, but since it is based on a solution development system, the same problem as in the above-described single layer resist arises, i.e., swelling of the upper resist layer. To remove this swelling problem, it has been proposed to develop the upper resist layer under dry conditions. For example, Japanese Unexamined Patent Publication (Kokai) No. 58-165321 teaches dry plasma development of the silicon-containing upper resist layer using plasma containing a gas of halogen compounds.

More particularly, Example 1 of Japanese Kokai 58-165321 discloses spin-coating polyimide on a silicon wafer to form a lower resist layer having a thickness of 1 µm. The lower resist layer is then coated with a mixture (5:1) of polyglycidyl methacrylate and dimethyldiphenylsilane to form an upper resist layer having a thickness of 0.2 µm. The resulting resist structure is pattern-wise exposed to electron beams, and then developed using a plasma of oxygen gas and Freon ^{R} gas. The unexposed area of the upper resist layer is thus removed. Next, the resist structure is dry etched. When the patterned upper resist layer containing Si is brought into contact with oxygen plasma during dry etching of the lower resist layer, SiO₂ is produced in the upper resist layer, which then becomes hard. As a result, a retention rate of the resist, i.e., ratio (%) of the thickness of the resist after development to that of the resist before development in the same area of the resist layer where the resist should be retained, can be improved.

Nevertheless, the prior art two layer resist process has a disadvantage in that a retention rate of the resist in the resulting resist patterns is not satisfactory because physical actions such as ion bombardment during the O₂-RIE adversely affect the improvement of such retention rate. Further, if the silicon-containing resist or polymer is prepared by introducing a silicon atom into the organic resist or polymer, an amount of the silicon in the resulting upper resist patterns is limited and, in practice, is not high enough to ensure a satisfactory resistance to the O₂-RIE of the upper resist layer during etching of the lower resist layer. It is, therefore, desired to provide an improved process for the resist pattern formation which ensures a formation of fine resist patterns of a submicron order at a high resolution and retention rate of the resist. It is also desired to confer a high resistance to dry etching such as the O₂-RIE to the resulting resist patterns.

Finally, document JP-A-62 256 804 discloses a pattern forming process invoving the steps of depositing an organic film on a substrate, and superimposing thereon a thin resist film that is to be used as a dry etch mask. The resist material is composed e.g. of a polymer having at least one silicon atom bonded thereto and an addition agent containing a benzene ring.

### Summary of the Invention

According to the present invention, there is provided a process for the formation of resist patterns comprising the preparation of a resist material by mixing a polymer having at least one silicon atom bonded thereto with an addition agent containing an aromatic group and/or a halogen atom which can bond to said polymer upon addition reaction when a mixture of said polymer and said addition agent is exposed to radiation, said polymer being used in admixture with the addition agent, coating said resist material on a substrate to form a resist layer, exposing said resist layer to a pattern of said radiation, and dry developing said exposed resist layer with an oxygen-containing etching gas by first introducing the oxygen-containing gas into a plasma chamber where it is subjected to microwave radiation to generate a plasma of the reaction gas, and then introducing the plasma treated gas into an etching chamber separated from the plasma generating chamber by a shield which stops the microwaves and the plasma, to form said resist patterns on said substrate.

The silicon-containing polymer (= polymer having at least one silicon atom bonded thereto) used as a main resist material in the present invention, as described hereinafter in detail, preferably contains at least one unsaturated bond such as a double bond and triple bond in a backbone chain of the recurring unit thereof, although the polymer containing only single bonds is also available.

Further, the addition agent used in combination with the silicon-containing polymer is preferably an olefin, azide, imide or derivatives thereof, and further contains at least one substituent selected from the group consisting of aromatic groups such as benzene ring and halogen atoms such as chlorine.

Developing of the exposed resist layer, as described above, is carried out with dry etching by using an oxygen-containing etching gas *as* the active species in the absence of plasma of the gas in an etching chamber positioned apart from a plasma generation chamber. This development process is generally referred to as a down flow etching process and will be further described hereinafter.

According to the present invention, there is also provided a process for the formation of resist patterns comprising forming a two-layered resist structure on a substrate having topographic features on a surface thereof by coating on said surface, in sequence, a lower resist layer having a layer of sufficient thickness to level said topographic features from an organic resist, and an upper resist layer from a resist material prepared by mixing a polymer having at least one silicon atom bonded thereto with an addition agent containing an aromatic group and/or a halogen atom which can bond to said polymer upon an addition reaction when a mixture of said polymer and said addition agent is exposed to radiation, said polymer being used in admixture with the addition agent, exposing said resist structure to a pattern of said radiation, dry developing said exposed resist layer with an oxygen-containing etching gas by first introducing the oxygen-containing gas into a plasma chamber where it is subjected to microwave radiation to generate a plasma of the reaction gas, and then introducing the plasma treated gas into an etching chamber separated from the plasma generating chamber by a shield which stops the microwaves and the plasma, to form said patterns of said upper resist layer on said lower resist layer, and further etching said lower resist layer, through said patterns of said upper resist layer as a mask, using a dry plasma etching method to etch an unmasked lower resist layer so that said patterns of said upper resist layer are transferred to said lower resist layer, thereby forming said resist patterns on said substrate.

### BRIEF DESCRIPTION OF THE DRAWINGS

Figures 1A to 1C are cross-sectional views showing, in sequence, the pattern formation process according to a single layer resist process of the present invention;
Figs. 2A to 2E are cross-sectional views showing, in sequence, the pattern formation process according to a two layer resist process of the present invention;
Fig. 3 is a cross-sectional view showing the down flow etching apparatus used in the pattern formation process of the present invention;
Fig. 4 is a graph showing the relationship between the Si content in the resist and ratio of the etching rate of said resist; and,
Fig. 5 is a graph showing the relationship between the energy level of radiation irradiated on the resist layer and the retention rate of the resist.

### DESCRIPTION OF THE PREFERRED EMBODIMENTS

In the practice of the present invention, a mixture of the silicon-containing polymer and the addition agent is used as the resist material. The silicon-containing polymer used may be optionally selected from a variety of well-known polymers which satisfy the requirements of the present process. The silicon-containing polymer preferably contains at least one unsaturated bond such as a double or triple bond. Typical examples of such useful silicon-containing polymers includes silylated polyacetylenes such as poly(1-methyl, 2-trimethylsilyl) acetylene, poly[1,2-bis(trimethylsilyl)]acetylene or the like and other silicon-containing polymers such as polymethylsilylmethacrylate, poly trimethylsilylmeth-acrylate, poly(3-pentamethyldisiloxane)methacrylate and the like, although the present invention is not restricted to these polymers.

In addition to the double bond-containing polymers, single bond-containing and triple bond-containing polymers are also available. An example of the single bond-containing polymers is 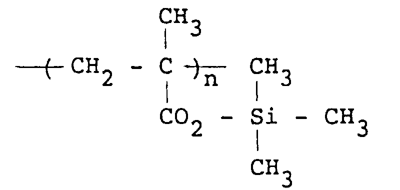 and an example of the triple bond-containing polymers is 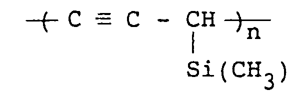 wherein n represents a polymerization degree.

The addition agent used in admixture with the silicon-containing polymer, as previously described, is preferably an olefin, azide, imide or derivatives thereof. The addition agent contains an aromatic group, for example a benzene ring, and/or a halogen atom, for example, chlorine or bromine atoms. Typical examples of useful addition agent include, for example, cinnamoyl chloride, diphenylacetylene, 2,3-diphenylbutadiene, benzyl cinnamate, 2-cinnamoylthiophene, 2,2-dimethoxy-2-phenylacetophenone, 4-azidebenzalcyclohexane, 1,4-diphenylpolybutadiene, 2,6-dichloroquinonechloroimide, 2,6-dibromoquinonechloroimide or chloranil.

The silicon-containing polymer and addition agent may be blended in a wide range of mixing ratios, depending upon factors such as desired results and the like.

If a single resist layer is desired, the resist material can be coated from a solution thereof onto a surface of the substrate such as a silicon substrate or wafer. Spin coating is preferably used. In addition, if appropriate, vacuum deposition or other coating methods may be used to form the resist layer.

Alternatively, if a two layer layer resist structure is desired, the above-described resist layer is used as an upper resist layer and is coated after the underlying resist layer "lower resist layer" has been coated on the substrate. The resist material for the lower resist layer is optional and can be selected from the well-known resist materials such as phenol resins, polyimide resins, polystyrene resins, epoxy resins, novolac resins, and the like.

The single resist layer or upper resist layer is then exposed to a desired pattern of light or radiation which can cause an addition reaction of the polymer and addition agent in the layer. Useful exposure sources include light such as visible light as well as radiation such as ultraviolet radiation, deep ultraviolet radiation, X-rays, electron beams and ion beams.

After patterning exposure, the resist layer is developed with the down flow etching method. Namely, the resist layer is dry developed with an oxygen-containing etching gas as an active species in the absence of plasma of said gas in an etching chamber positioned apart from a plasma generation chamber. The etching gas is downwardly introduced into said etching chamber, while the plasma of gas is retained in the plasma generation chamber. The etching gas is preferably produced from a mixture of oxygen (O₂) gas and carbon tetrafluoride (CF₄) gas. The resist material in an unexposed area of the resist layer is removed by this development.

The mechanism of the formation of the resist patterns described above is explained as follows:

If a mixed resist of the silicon-containing polymer (for example, polyacetylene with a silyl group) and the addition agent (for example, olefin) as the resist layer is exposed to a pattern of light or radiation, the following reaction occurs in an exposed area of the resist layer. 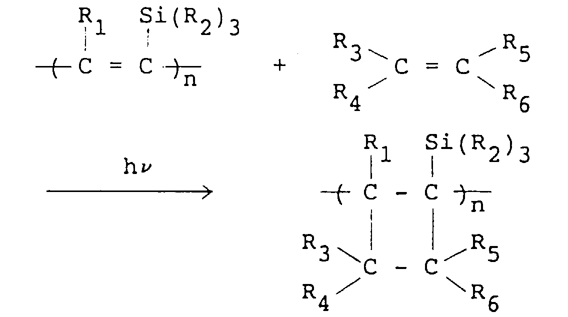 wherein
R₁, R₂, R₃, R₄, R₅ and R₆ may be the same or different and each represents a hydrogen atom or a substituted or unsubstituted alkyl or aryl group, and
n represents a polymerization degree. In the olefin of the above formula, if one or more of R₃, R₄, R₅ and R₆ are substituted by, for example, a phenyl group or a halogen atom (see, below), the resistance of the exposed resist to dry etching will be further increased. 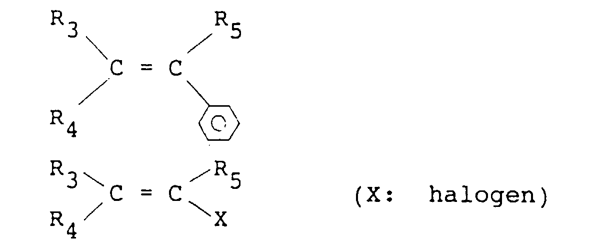
After exposure, the resist layer is developed with the down flow etching method using an oxygen-containing gas (for example, a mixed gas of O₂/CF₄). Etching of the resist is predominantly made in an unexposed area of the resist layer, and as a result, a negative resist pattern corresponding to the pattern of the exposure light or radiation is formed. Although this process has not been analyzed in depth, it is considered that, if plasma of O₂/CF₄ gas is generated upon application of a microwave, active species are simultaneously generated and then guided to the etching chamber where the active species are chemically reacted with the resist, and the reacted resist is etched off.

The negative resist pattern thus obtained can be used as a mask in the production of semiconductor devices or other devices. Further, if the resist layer is an upper resist layer of the two layer resist structure, the negative resist pattern can be used as a mask for etching in transferring a pattern of the upper resist layer to the lower resist layer. Etching in such instances can be advantageously carried out by using a dry plasma etching method such as O₂-RIE or ECR (electron cyclotron resonance) etching, although development of the lower resist layer according to the present invention is not restricted to these two methods.

In connection with the two layer resist process described above, the inventor further found that undesirable shifting of the resulting patterns in the two layer resist process can be effectively prevented if a mixture of high silicon polymer such as polyacetylene having an unsaturated bond in a backbone chain of the recurring unit thereof and at least two silicon atoms on a side chain thereof and addition agent such as ultraviolet absorbing agent is used as the resist material. Useful high silicon polymers include, for example, poly 4,4,6,6-tetramethyl-4,6-disila-2-heptyne (PTMDSH) and poly 4,4,7,7-tetramethyl-4,7-disila-2-octyne (PTMDSO): 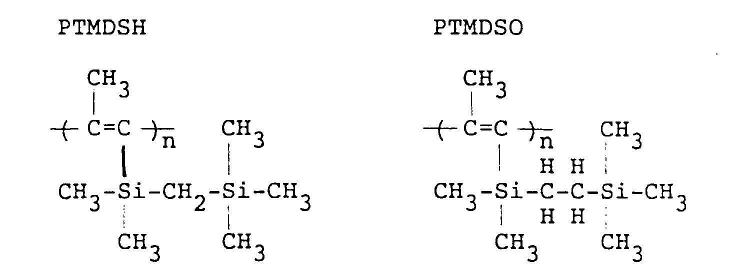 wherein n represents a polymerization degree.

Of course, in addition to these polymers, the polymers containing only one silicon atom on a side chain tereof such as poly 1-(trimethylsilyl)propyne (PTMSP) of the following structural formula: 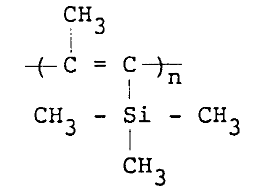 wherein n represents a polymerization degree, can provide good results.

The above two layer resist process, according to a preferred embodiment of the present invention, comprises the steps of:
forming a lower resist layer of the organic resist on a substrate to be processed to level topographic features of the substrate; further forming an upper resist layer of the above-described high silicon polymer and ultraviolet absorbing agent over the lower resist layer; patterning the upper resist layer by exposure to ultraviolet radiation; heating the substrate under a reduced pressure to remove the unreacted ultraviolet absorbing agent from the upper resist layer; developing the exposed upper resist layer with the down flow etching method using a O₂/CF₄ gas to obtain a pattern of the upper resist layer; and, etching the lower resist layer, through a mask of the patterned upper resist layer, with anisotropic plasma etching.

According to the process of the present invention, since the exposed silicon-containing resist layer (and the upper resist layer in the two layer resist process) is dry developed without using a developer solution, it is possible to easily produce fine resist patterns of a submicron order. As appreciated from the above description, this is because swelling of the resist layer is avoided due to the absence of the developer solution. Further, since the dry development is carried out in accordance with the down flow etching process, namely, development is not conducted in an atmosphere of O₂ plasma as in a conventional prior art dry development process, but is based on chemical reactions free from ion bombardment, the retention rate of the resist can be remarkably improved. Furthermore, since the silicon-containing polymer, whose silicon content can be easily adjusted to a high level, is used as the resist material, if the high silicon polymer is used as the upper resist layer in the two layer resist process, a satisfactorily increased resistance to O₂-RIE can be attained during RIE etching of the lower resist layer. In addition to these advantages, according to the process of the present invention, since pattern shifting of the resist during RIE etching of the lower resist layer is eliminated or reduced to negligible, proportions, the production yield of the devices, and the characteristics thereof, are improved.

The present invention will be further described with reference to the following examples to which the present invention is not restricted.

### Example 1:

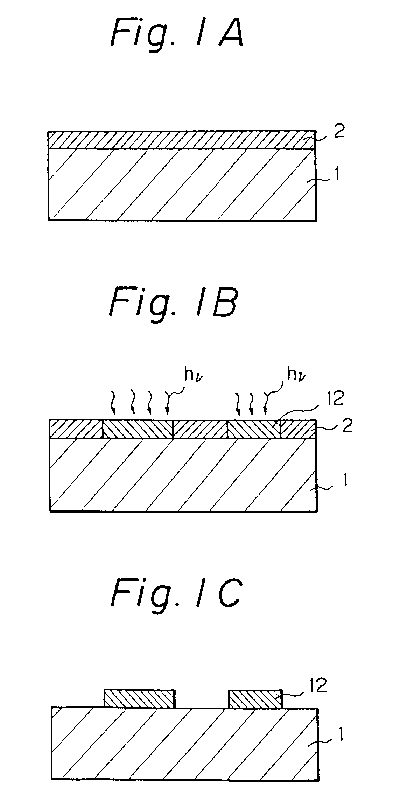

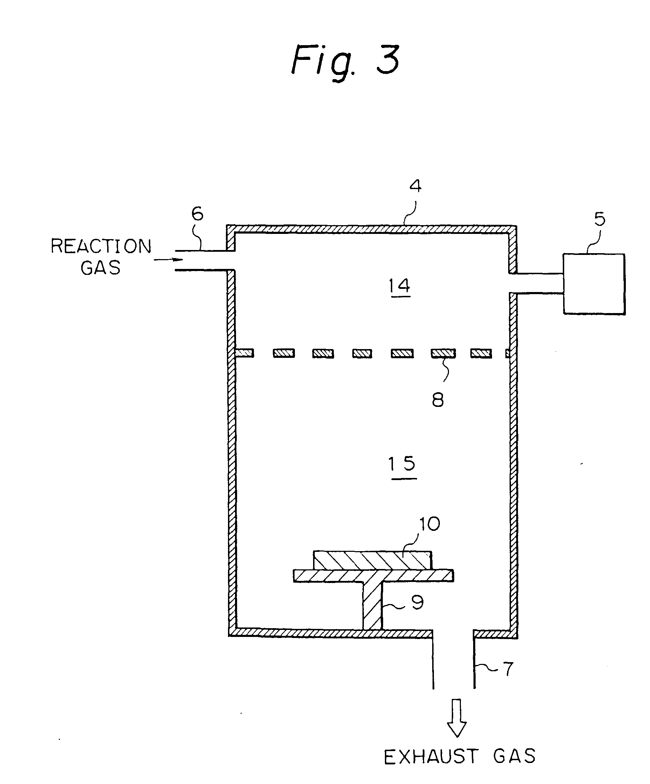

This is an example of the single layer resist process of the present invention and is described with reference to Figs. 1A to 1C and Fig. 3.

A mixture (2:1) of poly(1-methyl, 2-trimethylsilyl acetylene as the silicon-containing polymer and cinnamoyl chloride as the addition agent was dissolved in xylene to prepare a ca. 1% by weight resist solution, and the resist solution was spin-coated on the substrate. The substrate used herein was a silicon substrate or wafer having cleaned surfaces. After drying, as illustrated in Fig. 1A, a resist layer 2 having a layer thickness of about 400 nm was formed on an upper surface of the substrate 1.

Then, as illustrated in Fig. 1B, the resist layer 2 was exposed to patterning through a mask (not shown) to radiation from an Xe-Hg lamp for about 30 seconds. The contact exposure method was used and an illuminance on a surface of the wafer during exposure was about 5 mW/cm². An exposed area 12 of the resist layer 2 showed an increased resistance to dry etching in the next development step.

Development of the exposed resist layer was made in a developing apparatus of Fig. 3. The wafer 10 was placed in an etching chamber 15 of the developing apparatus 4 and carried with a wafer holder 9. A mixed gas of O₂/CF₄ as a reaction gas was introduced from a gas inlet 6 into a plasma generator 14 of the apparatus 4, and exhausted from a gas outlet 7 of the same apparatus 4. During development, microwave radiation (not shown) from a magnetron 5 was guided into the plasma generation chamber 14, and applied to the downwardly flowing reaction gas to generate plasma of the reaction gas. The plasma itself was stopped with a shield plate 8 for the microwave, but radicals of the atoms constituting the reaction gas (neutral active species) generated together with the gas plasma entered the etching chamber through openings of the shield plate 8. The exposed resist layer (not shown) of the wafer 10 was thus developed with the downwardly flowing plasma-free etching gas. The conditions used in this development step were as follows:

| | |
|---|---|
| Flow rate of O₂ | 1000 SCCM, |
| Flow rate of CF₄ | 500 SCCM, |
| Pressure | 800 Pa (6 Torr), |
| Power of microwave | 750 W. |

As a result of this development, a negative pattern 12 of the resist layer was formed on the substrate (see Fig. 1C). It was observed that the resist pattern had a retention rate of the resist of about 90% and a resolution of about 0.5 µm 1/s (line & space).

Further, the procedure of this example was repeated, except that the mixed gas of O₂/CF₄ was replaced by a mixed gas of O₂/CF₆ and a mixed gas of O₂/NF₃. In each instance, similar results were obtained.

### Example 2:

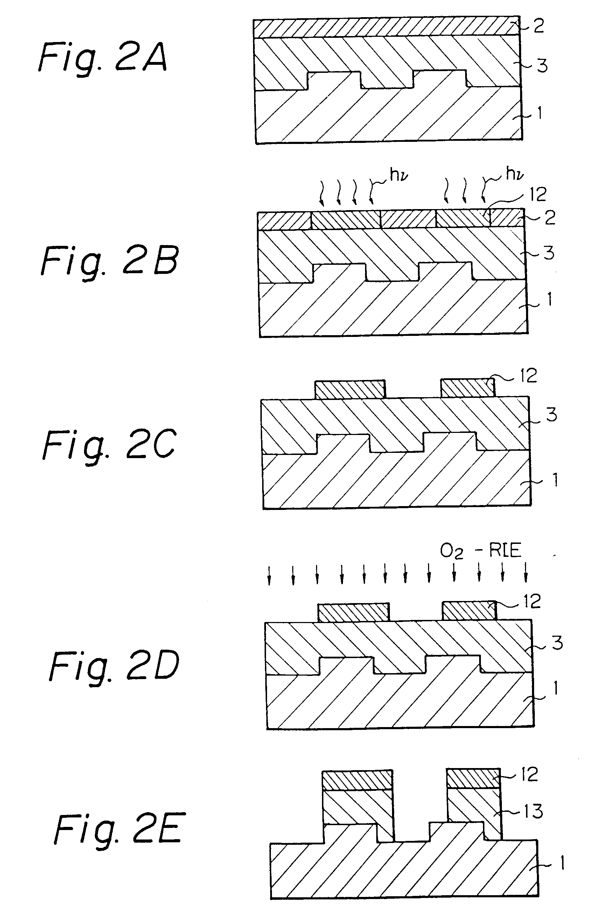

This is an example of the two layer resist process of the present invention and is described with reference to Figs. 2A to 2E.

Figure 2A illustrates a cross-section of the two layer resist structure used in this example. The substrate 1 was a silicon wafer and, as illustrated, contained topographic features. The resist structure was prepared as follows.

The novolac resist: OFPR-800, products of Tokyo Oka Laboratories Limited was spin-coated on an upper surface of the silicon wafer 1 to level the unevennesses of the wafer surface, and a lower resist layer 3 having a layer thickness of about 2 µm was thus formed on the silicon wafer 1. Thereafter, the same resist material as used in Example 1 was spin-coated on the lower resist layer 3 in accordance with the procedure of Example 1, and an upper resist layer 2 having a thickness of about 400 nm was produced.

After preparation of the resist structure, the upper resist layer 2 was to patterning exposed as in Example 1 and as shown in Fig. 2B. An exposed area 12 of the resist layer 2 on the lower resist layer 3 showed an increased resistance to dry etching.

The exposed upper resist layer 2 was then developed as in the development step of Example 1, and as shown in Fig. 2C, a negative pattern 12 of the resist layer was formed as a result of this development.

After the resist pattern 12 was formed, using this pattern as a mask, the underlying lower resist layer 3 was dry etched with O₂-RIE to transfer the pattern 12 to the layer 3 (see Fig. 2D). The conditions for this reactive dry etching using O₂ gas were as follows:

| | |
|---|---|
| Flow rate of O₂ | 100 SCCM, |
| Pressure | 4 Pa (0.03 Torr), |
| Output | 500 W. |

The unmasked area of the lower resist layer 13 was selectively etched as a result of this etching, and as shown in Fig. 2E, a negative pattern of the resist 12 plus 13 was eventually formed on the topographic features-bearing substrate 1. It was observed that the resist pattern had a thickness of 2 µm and a resolution of 0.5 µm 1/s.

### Example 3:

The procedure of Example 1 was repeated, except that polytrimethylsilylmethacrylate was used as the silicon-containing polymer and diphenylacetylene as the addition agent, respectively, and finally, a negative pattern of the resist layer was formed on the substrate. It was observed that the resist pattern had a retention rate of the resist of 60%, a resolution of 1 µm, and a sensitivity of 300 mJ.

### Example 4:

The procedure of Example 1 was repeated, except that poly[1,2-bis(trimethylsilyl)]acetylene] was used in place of poly(1-methyl, 2-trimethylsilyl)acetylene, and a negative resist pattern having a retention rate of the resist of 90%, a resolution of 0.5 µm, and a sensitivity of 120 mJ was formed.

### Example 5:

A mixture (3:2) of poly(1-methyl, 2-trimethylsilyl)acetylene as the silicon-containing polymer and 2',3-diphenylbutadiene as the addition agent was dissolved in xylene to prepare a ca. 1% by weight resist solution. The formation of a resist layer (thickness of about 300 nm), and the exposure and development were performed as in Example 1, and as a result, a negative resist pattern having a retention rate of the resist of 80%, a resolution of 0.5 µm, and a sensitivity of 150 mJ was obtained.

### Example 6:

The same procedure as in Example 5 was repeated, except that diphenylacetylene was used in place of 2,3-diphenylbutadiene, and a negative resist pattern having a retention rate of the resist of 95%, a resolution of 2 µm, and a sensitivity of 230 mJ was obtained.

### Example 7:

The same procedure as in Example 5 was repeated, except that benzyl cinnamate was used in place of 2,3-diphenylbutadiene, and a negative resist pattern having a retention rate of the resist of 75%, a resolution of 0.6 µm, and a sensitivity of 120 mJ was obtained.

### Example 8:

The same procedure as in Example 5 was repeated, except that 2-cinnamoylthiophene was used in place of 2,3-diphenylbutadiene, and a negative resist pattern having a retention rate of the resist of 85%, a resolution of 0.5 µm, and a sensitivity of 200 mJ was obtained.

### Example 9:

The same procedure as in Example 5 was repeated, except that 2,2-dimethoxy-2-phenylacetophenone was used in place of 2,3-diphenylbutadiene, and a negative resist pattern having a retention rate of the resist of 60%, a resolution of 1.0 µm, and a sensitivity of 100 mJ was obtained.

### Example 10:

The same procedure as in Example 5 was repeated, except that 4-azidobenzalcyclohexanone was used in place of 2,3-diphenylbutadiene, and a negative resist pattern having a retention rate of the resist of 75%, a resolution of 0.7 µm, and a sensitivity of 70 mJ was obtained.

### Example 11:

The same procedure as in Example 5 was repeated, except that 1,4-diphenylpolybutadiene was used in place of 2,3-diphenylbutadiene, and a negative resist pattern having a retention rate of the resist of 80%, a resolution of 1.5 µm, and a sensitivity of 200 mJ was obtained.

### Example 12:

A mixture (3:2) of poly trimethylsilyl methacrylate and diphenylacetylene was dissolved in methyl cellosolve acetate to prepare a ca. 8% by weight resist solution. A silicon wafer was spin-coated with this solution, followed by drying to form a resist layer (thickness of about 300 nm). The resist layer was subjected to contact exposure for about 30 seconds by using an Xe-Hg lamp and then baked at about 70°C in vacuum. Development of the exposed resist layer was then carried out under conditions of an O₂ flow rate of 1500 SCCM, a CF₄ flow rate of 300 SCCM, 400 Pa (3 Torr) and 750 W on the down flow developing apparatus as in Example 1. As a result, a negative resist pattern having a retention rate of the resist of 50%, a resolution of 1.5 µm, and a sensitivity of 200 mJ was obtained.

### Example 13:

The same procedure as in Example 12 was repeated, except that 2,3-diphenylbutadiene was used in place of diphenylacetylene, and a negative resist pattern having a retention rate of the resist of 60%, a resolution of 0.7 µm, and a sensitivity of 200 mJ was obtained.

### Example 14:

The same procedure as in Example 12 was repeated, except that 4-azidobenzalcyclohexanone was used in place of diphenylacetylene, and a negative resist pattern having a retention rate of the resist of 65%, a resolution of 0.6 µm, and a sensitivity of 80 mJ was obtained.

### Example 15:

This example followed the same procedures as performed in Example 2.

As shown in Fig. 2A, a wafer 1 was coated with a lower layer resist OFPR-800, and the resulting lower resist layer (thickness of about 2 µm) 3 was then coated with the resist of Example 5 as an upper resist layer 2. The upper resist layer 2 was exposed as in Example 5 (Fig. 2B), developed as in Example 5 (Fig. 2C), and then the lower resist layer 3 was etched, using the thus obtained negative upper pattern 12 as a mask, by O₂-RIE (O₂ of 50 SCCM, 2.7 Pa (0.02 Torr) and 500 W) (Fig. 2D). As a result, a negative pattern 13 having a thickness of about 2 µm and having a resolution of 0.5 µm was obtained wherein a dimensional shift from the upper layer resist pattern 12 was 0.1 µm or less (Fig. 2E).

When the negative patterns prepared in Examples 6 to 14 were used as the mask during O₂-RIE, similar results were obtained.

### Example 16:

This example followed the same procedures performed as in Example 2.

As shown in Fig. 2A, a wafer 1 was coated with a lower layer resist OFPR-800, and the resulting lower resist layer (thickness of about 2 µm) 3 was then coated with the resist of Example 5 as an upper resist layer 2. The upper resist layer 2 was exposed as in Example 5 (Fig. 2B), developed as in Example 5 (Fig. 2C), and then the lower resist layer 3 was etched, using the thus obtained negative upper pattern 12 as a mask, by electron cyclone resonance (ECR) etching (O₂ of 10 SCCM, 6.7 x 10⁻² Pa (5 x 10⁻⁴ Torr) and 800 W) in place of O₂-RIE (Fig. 2D). As a result, a negative pattern 13 having a thickness of about 2 µm being a resolution of 0.5 µm, was obtained wherein a dimensional shift from the upper layer resist pattern 12 being 0.05 µm or less (Fig. 2E).

In the case that each of the negative patterns prepared in Examples 6 to 14 were used as the mask during ECR etching, similar results were obtained.

### Example 17:

A mixture (3:2) of poly(1-methyl, 2-trimethylsilyl)acetylene as the silicon-containing polymer and 2,6-dichloroquinonchloroimide as the addition agent was mixed to prepare a resist material, and a wafer was spin-coated with the thus prepared resist material to form a resist layer having a thickness of about 300 nm. The resist layer was then subjected to contact exposure by using of an Xe-Hg lamp and baked at about 70°C in vacuum. Development of the exposed resist layer was then carried out under the conditions of a O₂ flow rate of 1000 SCCM, a CF₄ flow rate of 500 SCCM, 800 Pa (6 Torr) and 750 W, on the down flow developing apparatus as in Example 1, and as a result, a negative resist pattern having a retention rate of the resist of 90%, a resolution of 0.5 µm, and a sensitivity of 100 mJ was obtained.

### Example 18:

The same procedure as in Example 17 was repeated, except that 2,6-dibromoquinonchloroimide was used as the addition reaction initiator, and a negative resist pattern having a retention rate of the resist of 75%, a resolution of 0.7 µm, and a sensitivity of 200 mJ was obtained.

### Example 19:

The same procedure as in Example 18 was repeated, except that poly[1,2-bis(trimethylsilyl)acetylene was used as the silicon-containing polymer, and a negative resist pattern having a retention rate of the resist of 85%, a resolution of 0.5 µm, and a sensitivity of 100 mJ was obtained.

### Example 20:

The same procedure as in Example 18 was repeated, except that chloranil was used in place of 2,6-dichloroquinonchloroimide, and a negative resist pattern having a retention rate of the resist of 90%, a resolution of 0.6 µm, and a sensitivity of 150 mJ was obtained.

### Example 21:

The same procedure as in Example 18 was repeated, except that polytrimethylsilyl methacrylate was used as the silicon-containing polymer and the development conditions for the down flow development were changed to an O₂ of 1500 SCCM, a CF₄ of 300 SCCM, 400 Pa (3 Torr) and 750 W. A negative resist pattern having a retention rate of the resist of 60%, a resolution of 0.6 µm, and a sensitivity of 100 mJ was obtained.

### Example 22:

The same procedure as in Example 20 was repeated, except that chloranil was used in place of 2,6-dichloroquinonchloroimide, and a negative resist pattern having a retention rate of the resist of 70%, a resolution of 0.7 µm, and a sensitivity of 120 mJ was obtained.

### Example 23:

This example followed the procedures as performed in Example 2.

As shown in Fig. 2A, a wafer 1 was coated with a lower layer resist OFPR-800, and the resulting lower resist layer (thickness of about 2 µm) 3 was then coated with the resist of Example 18 as an upper resist layer 2. The upper resist layer 2 was exposed as in Example 2 (Fig. 2B), developed as in Example 2 (Fig. 2C), and then the lower resist layer 3 was etched, using the thus obtained upper negative pattern 12 as a mask, by O₂-RIE (O₂ of 50 SCCM, 2.7 Pa (0.02 Torr) and 500 W) (Fig. 2D). As a result, a negative pattern having a thickness of about 2 µm and having a resolution of 0.5 µm was obtained wherein a dimensional shift from the upper layer resist pattern 12 was 0.1 µm or less (Fig. 2E).

When the negative patterns prepared in Examples 19 to 23 were used as the mask during O₂-RIE, similar results were obtained.

### Example 24:

This example followed the procedures as performed in Example 2.

As shown in Fig. 2A, a wafer 1 was coated with a lower layer resist OFPR-800, and the resulting lower resist layer (thickness of about 2 µm) 3 was then coated with the resist of Example 18 as an upper resist layer 2. The upper resist layer 2 was exposed as in Example 2 (Fig. 2B), developed as in Example 2 (Fig. 2C), and then the lower resist layer 3 was etched, using the thus obtained negative upper pattern 12 as a mask, by electron cyclone resonance (ECR) etching (O₂ of 10 SCCM, 6.7 x 10⁻² Pa (5 x 10⁻⁴ Torr) and 800 W) in place of O₂-RIE (Fig. 2D). As a result, a negative pattern 13 having a thickness of about 2 µm and having a resolution of 0.5 µm was obtained wherein a dimensional shift from the upper layer resist pattern 12 was 0.05 µm or less (Fig. 2E).

When the negative patterns prepared in Examples 19 to 23 were used as the mask during ECR etching, similar results were obtained.

### Example 25:

This is an example of the two layer resist process of the present invention.

The novolac resist: OFPR-800 was spin-coated on an upper surface of the silicon wafer to form a lower resist layer having a thickness of 1.5 µm, the resist layer was then baked at 200°C, and after baking, a mixture (2:1) of poly 4,4,6,6-tetramethyl-4,6-disila-2-heptyne (PTMDSH) and 2,6-dichloroquinone-4-chloroimide (DCQI) was dissolved in xylene and the resulting resist solution was spin-coated on the lower resist layer previous formed, whereby an upper resist layer having a thickness of 0.45 µm was produced.

After preparation of the two layer resist structure, the upper resist layer was subjected to patterning contact exposure by using of a high pressure Xe-Hg lamp as an exposure source. The exposed upper resist layer was then heated at 50°C for 5 minutes under a reduced pressure of 6.7 Pa (0.05 Torr) to remove unreacted DCQI therefrom as a result of vaporization of the same.

Thereafter, the silicon wafer was placed in a dry etching apparatus. Using this apparatus, the down flow etching was performed as follows: into a plasma generation chamber wherein the O₂ flow rate of 1000 cc/min, CF₄ flow rate of 500 cc/min and reduced pressure of 800 Pa (6 Torr) were maintained, a microwave of output 700 W was introduced to generate a plasma of the mixed gas of O₂ and CF₄. The plasma was then introduced into an etching chamber through a plasma shield plate of metal mesh. Only radicals of the mixed gas were downwardly flowed within the etching chamber, and the wafer placed in the etching chamber was place in contact with said radicals, and the upper resist layer thereof was selectively etched in conformity with the pattern of the exposure radiation. A negative pattern of the upper resist layer was obtained on the lower resist layer of the resist structure.

Subsequent to the patterning of the upper resist layer, using this patterned layer as a mask, the underlying lower resist layer was dry etched with O₂-RIE. The RIE conditions were: an O₂ flow rate of 20 cc/min, a vacuum of 10.6 Pa (0.08 Torr), and an RF power of 500 W. A pattern of the upper resist layer was exactly transferred to the underlying lower resist layer, no pattern shift was observed.

A ratio of etching rate of the lower layer resist to the upper layer resist was then determined. The results of determination demonstrated that the ratio of the etching rate in this example was 68 times, while the ratio in another two layer resist structure using poly 1-(trimethylsilyl)propyne (PTMSP) was about 20 times.

### Example 26:

The procedure of Example 25 was repeated, except that PTMDSH was replaced with poly 4,4,7,7-tetramethyl-4,7-disila-2-octyne (PTMDSO). A pattern of the upper resist layer was exactly transferred to the underlying lower resist layer, and no pattern shift was observed. Further, it was determined that the ratio of the etching rate in this example was 52 times.

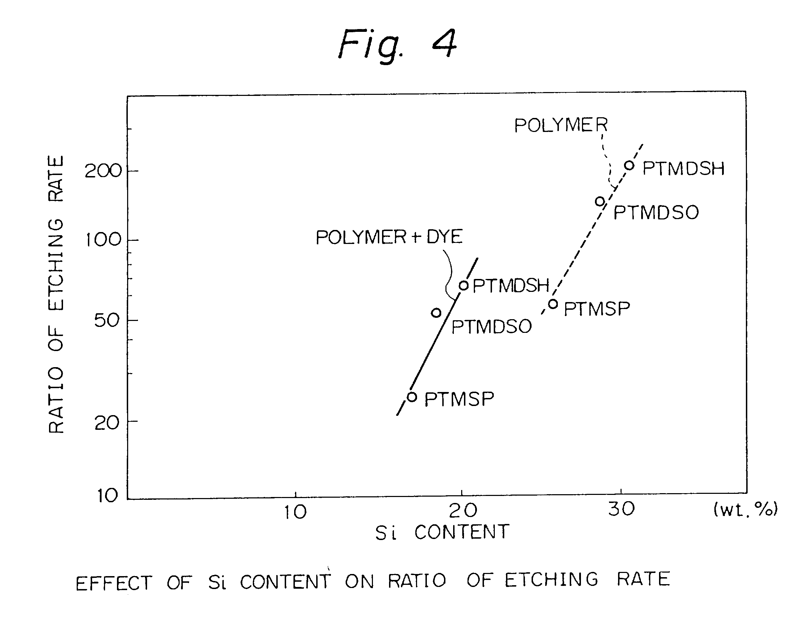

The results of the determination of the ratio of the etching rate in these examples are plotted in Fig. 4, together with the results for poly 1-(trimethylsilyl)propyne (PTMSP) used in place of PTMDSH in Example 25. The graph of Fig. 4 clearly shows that the ratio of the etching rate is improved with an increase of the Si content in the silicon-containing polymer as the upper resist layer.

### Example 27:

The procedures of Examples 25 and 26 were repeated to ascertain an effect of the energy of the radiation used in patterning on the retention rate of the resist after exposure, except that a KrF excimer laser (wavelength of 248 nm) was used as the patterning radiation.

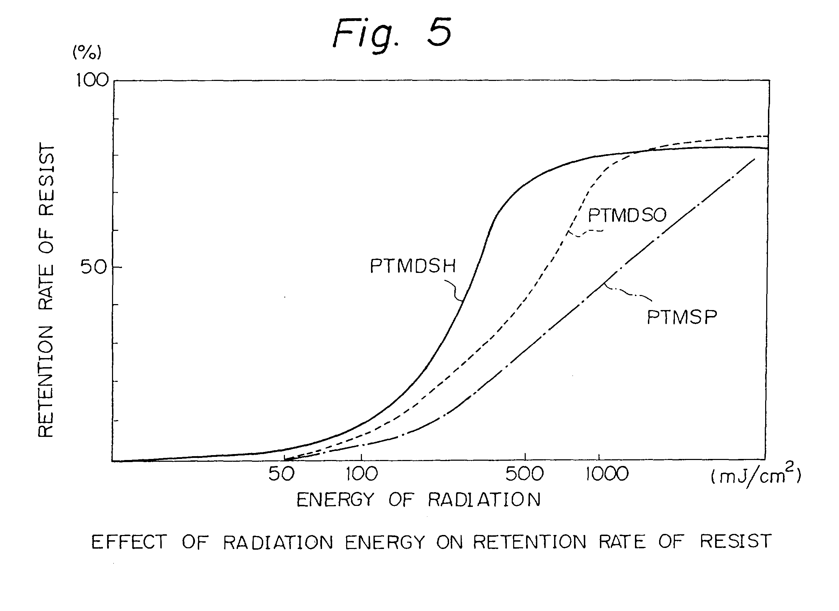

The results plotted in Fig. 5 clearly show that PTMDSH and PTMDSO have an excellent sensitivity, although the sensitivity of PTMSP is also acceptable.

## Claims

1. A process for the formation of resist patterns comprising:
preparing a resist material by mixing a polymer having at least one silicon atom bonded thereto with an addition agent containing an aromatic group and/or a halogen atom which can bond to said polymer upon addition reaction when a mixture of said polymer and said addition agent is exposed to radiation, said polymer being used in admixture with the addition agent is
coating said resist material on a substrate (1) to form a resist layer (2),
exposing said resist layer to a pattern of said radiation, and
dry developing said exposed resist layer with an oxygen-containing etching gas by first introducing the oxygen-containing gas into a plasma chamber (14) where it is subjected to microwave radiation to generate a plasma of the reaction gas, and then introducing the plasma treated gas into an etching chamber (15) separated from the plasma generating chamber (14) by a shield (8) which stops the microwaves and the plasma, to form said resist patterns on said substrate.

2. A process according to claim 1, wherein said polymer contains at least one unsaturated bond in a backbone chain of the recurring unit thereof.

3. A process according to claim 1, wherein said polymer is silylated polyacetylene.

4. A process according to claim 1, wherein said addition agent is an olefin, azide, imide, or derivatives thereof containing said aromatic group and/or halogen atom.

5. A process according to claim 1, wherein said resist material is coated from a solution thereof on said substrate.

6. A process according to claim 1, wherein said radiation used in the exposure step induces an addition reaction of said addition agent onto said polymer, and is one of light, ultraviolet radiation, deep ultraviolet radiation, X-rays, electron beams, and ion beams.

7. A process according to claim 1, wherein said oxygen-containing etching gas used in dry development step is downwardly introduced into said etching chamber (15) from said plasma generation chamber (14), while said plasma of said gas is retained in said plasma generation chamber.

8. A process according to claim 7, wherein said oxygen-containing etching gas is produced from a mixture of oxygen gas and carbon tetrafluoride gas in said plasma generation chamber (14).

9. A process according to claim 1, wherein said resist patterns are negative resist patterns and are used as a mask when said substrate is patterned by etching in the producing of semiconductor devices.

10. A process for the formation of resist patterns comprising:
forming a two-layered resist structure (2, 3) on a substrate (1) having topographic features on a surface thereof by coating on said surface, in sequence, a lower resist layer (3) having a layer of sufficient thickness to level said topographic features from an organic resist, and an upper resist layer (2) from a resist material prepared by mixing a polymer having at least one silicon atom bonded thereto with an addition agent containing an aromatic group and/or a halogen atom which can bond to said polymer upon an addition reaction when a mixture of said polymer and said addition agent is exposed to radiation, said polymer being used in admixture with the addition agent,
exposing said resist structure (12) to a pattern of said radiation,
dry developing said exposed resist layer with an oxygen-containing etching gas by first introducing the oxygen-containing gas into a plasma chamber (14) where it subjected to microwave radiation to generate a plasma of the reaction gas, and then introducing the plasma treated gas into an etching chamber (15) separated from the plasma generating chamber (14) by a shield (8) which stops the microwaves and the plasma, to form said patterns (12) of said upper resist layer (2) on said lower resist layer, and further
etching said lower resist layer, through said patterns of said upper resist layer as a mask, using a dry plasma etching method to etch an unmasked lower resist layer so that said patterns of said upper resist layer are transferred to said lower resist layer, thereby forming said resist patterns on said substrate (1).

11. A process according to claim 10, wherein said polymer contains at least one unsaturated bond in a backbone chain of the recurring unit thereof.

12. A process according to claim 10 wherein said silicon-containing polymer is silylated polyacetylene.

13. A process according to claim 10 wherein said addition agent is an olefin, azide, imide, or derivatives thereof containing said aromatic group and/or halogen atom.

14. A process according to claim 10 wherein said resist material forming said upper resist layer is coated from a solution thereof on said lower resist layer.

15. A process according to claim 10 wherein said radiation used in the exposure step can induce an addition reaction of said addition agent onto said polymer, and is light, ultraviolet radiation, deep ultraviolet radiation, X-rays, electron beams or ion beams.

16. A process according to claim 10 wherein said oxygen-containing etching gas used in the dry development step is downwardly introduced into said etching chamber from said plasma generation chamber, while said plasma of said gas is retained in said plasma generation chamber.

17. A process according to claim 16 wherein said oxygen-containing etching gas is produced from a mixture of oxygen gas and carbon tetrafluoride gas in said plasma generation chamber.

18. A process according to claim 10 wherein said dry plasma etching method is O₂-reactive ion etching.

19. A process according to claim 10 wherein said dry plasma etching method is an electron cyclotron resonance etching.

20. A process according to claim 10 wherein said polymer is polyacetylene having an unsaturated bond in a backbone chain of the recurring unit thereof and at least two silicon atoms on a side chain thereof, and said addition agent is an ultraviolet absorbina agent.

21. A process according to claim 20 wherein after exposure of said resist structure to a pattern of ultraviolet radiation and before development of said exposed resist structure, said exposed resist structure is heated under a reduced pressure to remove an unreacted ultraviolet absorbing agent therefrom.

22. A process according to claim 20 wherein said silicon-containing polyacetylene is poly 4,4,6,6-tetramethyl-4,6-disila-2-heptyne or poly 4,4,7,7-tetramethyl-4,7-disila-2-octyne.

23. A process according to claim 10 wherein said resist patterns are negative resist patterns and are used as a mask when said substrate is patterned by etching in the production of semiconductor devices.

24. A process according to any one of claims 1 to 23, wherein said shield is a mesh-like shield (8).

## Patentansprüche

1. Verfahren zur Herstellung von Resistbildern, bei dem:
ein Resistmaterial hergestellt wird durch Vermischen eines Polymers, das mindestens ein Siliciumatom daran gebunden aufweist, mit einem Additionsmittel, das eine aromatische Gruppe und/oder ein Halogenatom enthält, das durch Additionsreaktion an das Polymer binden kann, wenn ein Gemisch aus dem Polymer und dem Additionsmittel Strahlung ausgesetzt wird, wobei das Polymer im Gemisch mit dem Additionsmittel verwendet wird,
ein Substrat (1) zur Bildung einer Resistschicht (2) mit dem Resistmaterial beschichtet wird,
die Resistschicht einem Muster der Strahlung ausgesetzt wird und
die bestrahlte Resistschicht mit einem sauerstoffhaltigen Ätzgas trocken entwickelt wird, indem zuerst das sauerstoffhaltige Gas in eine Plasmakammer (14) eingeführt wird, in der es Mikrowellenstrahlung ausgesetzt wird, um ein Plasma des Reaktionsgases zu erzeugen, und dann das mit dem Plasma behandelte Gas in eine Ätzkammer (15) eingeführt wird, die durch eine Abschirmung (8), welche die Mikrowellen und das Plasma abhält, von der Plasmaerzeugungskammer (14) abgetrennt ist, so daß die Resistbilder auf dem Substrat gebildet werden.

2. Verfahren nach Anspruch 1, wobei das Polymer mindestens eine ungesättigte Bindung in der Hauptkette seiner Wiederholungseinheit enthält.

3. Verfahren nach Anspruch 1, wobei das Polymer silyliertes Polyacetylen ist.

4. Verfahren nach Anspruch 1, wobei das Additionsmittel ein Olefin, Azid, Imid oder Derivat davon ist, welches die aromatische Gruppe und/oder das Halogenatom enthält.

5. Verfahren nach Anspruch 1, wobei das Substrat mit dem Resistmaterial aus einer Lösung davon beschichtet wird.

6. Verfahren nach Anspruch 1, wobei die in dem Bestrahlungsschritt verwendete Strahlung eine Additionsreaktion des Additionsmittels an das Polymer auslöst und es sich dabei um eine der Strahlungsarten Licht, UV-Strahlung, Tief-UV-Strahlung, Röntgenstrahlen, Elektronenstrahlen und Ionenstrahlen handet.

7. Verfahren nach Anspruch 1, wobei das in der Trockenentwicklungsstufe verwendete sauerstoffhaltige Ätzgas aus der Plasmaerzeugungskammer (14) nach unten in die Ätzkammer (15) eingeführt wird, während das Plasma des Gases in der Plasmaerzeugungskammer zurückgehalten wird.

8. Verfahren nach Anspruch 7, wobei das sauerstoffhaltige Ätzgas in der Plasmaerzeugungskammer (14) aus einem Gemisch aus Sauerstoffgas und Tetrafluorkohlenstoffgas hergestellt wird.

9. Verfahren nach Anspruch 1, wobei die Resistbilder negative Resistbilder sind und als Maske verwendet werden, wenn das Substrat zur Herstellung von Halbleitereinrichtungen durch Ätzen mit einem Bild versehen wird.

10. Verfahren zur Herstellung von Resistbildern, bei dem:
eine zweischichtige Resiststruktur (2, 3) auf einem Substrat (1) gebildet wird, das topographische Merkmale auf einer Oberfläche davon aufweist, indem die Oberfläche nacheinander beschichtet wird mit einer unteren Resistschicht (3), die eine zur Nivellierung der topographischen Merkmale eines organischen Resists ausreichend dicke Schicht aufweist, und einer oberen Resistschicht (2) aus einem Resistmaterial, das hergestellt wird, durch Vermischen eines Polymers, das mindestens ein Siliciumatom daran gebunden aufweist, mit einem Additionsmittel, das eine aromatische Gruppe und/oder ein Halogenatom enthält, das durch Additionsreaktion an das Polymer binden kann, wenn ein Gemisch aus dem Polymer und dem Additionsmittel Strahlung ausgesetzt wird, wobei das Polymer im Gemisch mit dem Additionsmittel verwendet wird,
die Resiststruktur (12) einem Muster der Strahlung ausgesetzt wird,
die bestrahlte Resistschicht mit einem sauerstoffhaltigen Ätzgas trocken entwickelt wird, indem zuerst das sauerstoffhaltige Gas in eine Plasmakammer (14) eingeführt wird, in der es Mikrowellenstrahlung ausgesetzt wird, um ein Plasma des Reaktionsgases zu erzeugen, und dann das mit dem Plasma behandelte Gas in eine Ätzkammer (15) eingeführt wird, die durch eine Abschirmung (8), welche die Mikrowellen und das Plasma abhält, von der Plasmaerzeugungskammer (14) abgetrennt ist, um die Bilder (12) der oberen Resistschicht (2) auf der unteren Resistschicht zu bilden, und ferner
die untere Resistschicht durch die Bilder der oberen Resistschicht als Maske unter Anwendung eines Trockenplasmaätzverfahrens zum Ätzen einer unmaskierten unteren Resistschicht geätzt wird, so daß die Bilder der oberen Resistschicht auf die untere Resistschicht übertragen werden, wodurch die Resistbilder auf dem Substrat (1) gebildet werden.

11. Verfahren nach Anspruch 10, wobei das Polymer mindestens eine ungesättigte Bindung in der Hauptkette seiner Wiederholungseinheit aufweist.

12. Verfahren nach Anspruch 10, wobei das siliciumhaltige Polymer silyliertes Polyacetylen ist.

13. Verfahren nach Anspruch 10, wobei das Additionsmittel ein Olefin, Azid, Imid oder Derivat davon ist, welches die aromatische Gruppe und/oder das Halogenatom enthält.

14. Verfahren nach Anspruch 10, wobei die untere Resistschicht mit dem die obere Resistschicht bildenden Resistmaterial aus einer Lösung davon beschichtet wird.

15. Verfahren nach Anspruch 10, wobei die in dem Bestrahlungsschritt verwendete Strahlung eine Additionsreaktion des Additionsmittels an das Polymer auslösen kann und es sich dabei um eine der Strahlungsarten Licht, UV-Strahlung, Tief-UV-Strahlung, Röntgenstrahlung, Elektronenstrahlen oder Ionenstrahlen handelt.

16. Verfahren nach Anspruch 10, wobei das in der Trockenentwicklungsstufe verwendete sauerstoffhaltige Ätzgas aus der Plasmaerzeugungskammer nach unten in die Ätzkammer eingeführt wird, während das Plasma des Gases in der Plasmaerzeugungskammer zurückgehalten wird.

17. Verfahren nach nach Anspruch 16, wobei das sauerstoffhaltige Ätzgas in der Plasmaerzeugungskammer aus einem Gemisch aus Sauerstoffgas und Tetrafluorkohlenstoffgas hergestellt wird.

18. Verfahren nach Anspruch 10, wobei das Trockenplasmaätzverfahren Ätzen mit reaktiven O₂-Ionen ist.

19. Verfahren nach Anspruch 10, wobei das Trockenplasmaätzverfahren Elektronencyclotron-Resonanzätzen ist.

20. Verfahren nach Anspruch 10, wobei das Polymer Polyacetylen mit einer ungesättigten Bindung in der Hauptkette seiner Wiederholungseinheit ist und mindestens zwei Siliciumatome an einer Seitenkette davon aufweist und das Additionsmittel ein UV-absorbierendes Mittel ist.

21. Verfahren nach Anspruch 20, wobei nachdem die Resiststruktur einem UV-Strahlungsmuster ausgesetzt worden ist und vor der Entwicklung der bestrahlten Resiststruktur die bestrahlte Resiststruktur unter verringertem Druck erhitzt wird, um das nichtumgesetzte UV-absorbierende Mittel davon zu entfernen.

22. Verfahren nach Anspruch 20, wobei das siliciumhaltige Polyacetylen Poly-4,4,6-6-tetramethyl-4, 6-disila-2-heptin oder Poly-4,4,7,7-tetramethyl-4,7-disila-2-octin ist.

23. Verfahren nach Anspruch 10, wobei die Resistbilder negative Resistbilder sind und als Maske verwendet werden, wenn das Substrat zur Herstellung von Halbleitereinrichtungen durch Ätzen mit einem Bild bemustert wird.

24. Verfahren nach einem der Ansprüche 1 bis 23, wobei die Abschirmung eine siebähnliche Abschirmung (8) ist.

## Revendications

1. Procédé de formation de motifs résist comprenant les étapes de :
préparer un matériau résist en mélangeant un polymère ayant au moins un atome de silicium qui y est lié avec un agent d'addition contenant un groupe aromatique et/ou un atome d'halogène qui peut se fixer audit polymère par réaction d'addition quand on expose un mélange dudit polymère et dudit agent d'addition à de la radiation, ledit polymère étant utilisé en mélange avec l'agent d'addition,
déposer ledit matériau résist sur un substrat (1) pour former une couche résist (2),
exposer ladite couche résist à un motif de ladite radiation, et
développer à sec ladite couche résist exposée avec un gaz de gravure contenant de l'oxygène en introduisant d'abord le gaz contenant de l'oxygène dans une chambre de plasma (14) où il est soumis à la radiation de micro-ondes pour générer un plasma de gaz de réaction, et ensuite en introduisant le gaz traité pour former un plasma dans une chambre de gravure (15) séparée de la chambre générant le plasma (14) à l'aide d'un écran (8) qui arrête les micro-ondes et le plasma, pour former lesdits motifs résist sur ledit substrat.

2. Procédé selon la revendication 1, où ledit polymère contient au moins une liaison insaturée dans le squelette de chaîne de son unité répétée.

3. Procédé selon la revendication 1, où ledit polymère est du polyacétylène silylé.

4. Procédé selon la revendication 1, où ledit agent d'addition est une oléfine, un azide, un amide ou un de leurs dérivés contenant ledit groupe aromatique et/ou l'atome d'halogène.

5. Procédé selon la revendication 1, où ledit matériau résist est déposé à partir de sa solution sur ledit substrat.

6. Procédé selon la revendication 1, où ladite radiation utilisée à l'étape d'exposition provoque la réaction d'addition dudit agent d'addition sur ledit polymère, et comprend une radiation lumineuse, radiation ultraviolette, radiation d'ultraviolet lointain, des rayons X, faisceaux électroniques et faisceaux ioniques.

7. Procédé selon la revendication 1, où ledit gaz de gravure contenant de l'oxygène utilisé à l'étape de développement à sec est introduit vers le bas dans ladite chambre de gravure (15) à partir de ladite chambre de formation de plasma (14), tandis que ledit plasma dudit gaz est retenu dans ladite chambre de formation du plasma.

8. Procédé selon la revendication 7, où ledit gaz de gravure contenant de l'oxygène est produit à partir d'un mélange de gaz oxygène et de gaz tétrafluorure de carbone dans ladite chambre de formation de plasma (14).

9. Procédé selon la revendication 1, où lesdits motifs résist sont des motifs résist négatifs et sont utilisés comme masque lorsque ledit substrat est exposé pour former des motifs par gravure dans la production de composants semi-conducteurs.

10. Procédé de formation de motifs résist comprenant les étapes de :
former une structure résist bicouche (2, 3) sur un substrat (1) ayant des caractéristiques topographiques sur une de ses surfaces en déposant sur ladite surface, successivement, une couche résist inférieure (3) ayant une couche d'épaisseur suffisante pour niveler lesdites caractéristiques topographiques d'un résist organique, et une couche résist supérieure (2) à partir d'un matériau résist préparé en mélangeant un polymère ayant au moins un atome de silicium qui y est lié avec un agent d'addition contenant un groupe aromatique et/ou un atome d'halogène qui peut se fixer audit polymère par une réaction d'addition quand un mélange dudit polymère et dudit agent d'addition est exposé à de la radiation, ledit polymère étant utilisé en mélange avec l'agent d'addition,
exposer ladite structure résist (12) à un motif de ladite radiation,
développer à sec ladite couche résist exposée avec un gaz de gravure contenant de l'oxygène en introduisant d'abord le gaz contenant de l'oxygène dans une chambre de plasma (14) où il est soumis à une radiation micro-ondes pour générer un plasma de gaz de réaction, et ensuite en introduisant le gaz traité par le plasma dans une chambre de gravure (15) séparée de la chambre générant le plasma (14) par un écran (8) qui arrête les micro-ondes et le plasma, pour former lesdits motifs (12) de ladite couche résist supérieure (2) sur ladite couche résist inférieure, et en plus
graver ladite couche résist inférieure, à travers lesdits motifs de ladite couche résist supérieure comme masque, en utilisant un procédé de gravure par plasma à sec pour graver une couche résist inférieure non masquée de sorte que lesdits motifs de la couche résist supérieure soient transférés à ladite couche résist inférieure, ce qui forme ainsi lesdits motifs résist ledit substrat (1).

11. Procédé selon la revendication 10, où ledit polymère contient au moins une liaison insaturée dans le squelette de chaîne de son unité répétée.

12. Procédé selon la revendication 10, où ledit polymère contenant du silicium est un polyacétylène silylé.

13. Procédé selon la revendication 10, où ledit agent d'addition est une oléfine, un azide, imide ou un de leurs dérivés contenant ledit groupe aromatique et/ou un atome d'halogène.

14. Procédé selon la revendication 10, où ledit matériau résist formant ladite couche résist supérieure est déposé à partir d'une de ses solutions sur ladite couche inférieure de résist.

15. Procédé selon la revendication 10, où ladite radiation utilisée à l'étape d'exposition peut induire une réaction d'addition dudit agent d'addition sur ledit polymère, et une radiation lumineuse, une radiation ultraviolette, une radiation d'ultraviolet lointain, des rayons X, des faisceaux électroniques ou des faisceaux ioniques.

16. Procédé selon la revendication 10, où ledit gaz de gravure contenant de l'oxygène utilisé à l'étape de développement à sec est introduit vers le bas dans ladite chambre de gravure à partir de la chambre de formation de plasma, tandis que ledit plasma dudit gaz est retenu dans ladite chambre de formation de plasma.

17. Procédé selon la revendication 16, où ledit gaz de gravure contenant de l'oxygène est produit par un mélange de gaz oxygène et de gaz tétrafluorure de carbone dans ladite chambre de formation de plasma.

18. Procédé selon la revendication 10, où ledit procédé de gravure par plasma à sec est un procédé de gravure 02-ion réactif.

19. Procédé selon la revendication 10, où ledit procédé de gravure par plasma à sec est un procédé de gravure par résonance cyclotron électronique.

20. Procédé selon la revendication 10, où ledit polymère est un polyacétylène ayant une liaison insaturée dans le squelette de chaîne de son unité répétée et au moins deux atomes de silicium sur une de ses chaînes latérales, et ledit agent d'addition est un agent absorbant l'ultraviolet.

21. Procédé selon la revendication 20, où après exposition de ladite structure résist à un motif de radiation ultraviolette et avant développement de ladite structure résist exposée, ladite structure résist exposée est chauffée sous pression réduite pour éliminer l'agent absorbant l'ultraviolet qui n'a pas réagi.

22. Procédé selon la revendication 20, où ledit polyacétylène contenant du silicium est le poly-4,4,6,6-tétraméthyl-4,6-disila-2-heptyne ou le poly-4,4,7,7-tétraméthyl-4,7-disila-2-octyne.

23. Procédé selon la revendication 10, où lesdits motifs résist sont des motifs résist négatifs et sont utilisés comme masque lorsque ledit substrat est gravé pour former des motifs dans la production des composants semi-conducteurs.

24. Procédé selon l'une quelconque des revendications 1 à 23, où ledit écran est un écran formant des mailles (8).
